# EUROPEAN PATENT APPLICATION

(11) **EP 4 807 933 A1**
(43) Date of publication of application: **16.09.2026**
(21) Application number: 25163894.6
(22) Date of filing: 14.03.2025
(51) Int. Cl.: H02J 3/00, H02J 3/38

(54) **METHOD AND SYSTEM FOR DYNAMIC ADJUSTMENT OF POWER SYNCHRONISATION**

(71) Applicant: GE Vernova Technology GmbH, 5400 Baden (CH)
(72) Inventor: BERG, Matias Uolevi, 33730 Pirkanmaa (FI); HART, Philip, New York 12309-1027 (US)
(74) Representative: Openshaw & Co.

(57) **Abstract**

A method of adjusting active power synchronisation in a grid-connected electrical system. The method comprising the steps of determining at least one of grid voltage amplitude (V), internal voltage amplitude (E), or grid impedance during system operation, estimating the phase angle difference (θ) between the internal voltage and grid voltage, calculating estimated angle-to-active power dynamics of the system based on determining at least one of the grid voltage amplitude (V), internal voltage amplitude (E), grid impedance and the phase angle difference (θ) between the internal voltage and grid voltage, and assigning the result as *G_{θ-to-P,est}*(*s*), determining nominal angle-to-active power dynamics based on predefined system design parameters and assigning the result as *G_{θ-to-P,nom}*(*s*), calculating an adjustment gain as the ratio of *G_{θ-to-P,nom}*(*s*) to *G_{θ-to-P,est}*(*s*); and applying the adjustment gain to an active power synchronisation loop by modifying at least one control parameter or modifying the signal within the loop based on the calculated adjustment gain.

## Description

### FIELD OF THE INVENTION

The present invention relates to a method and system for adjusting power synchronisation in electrical systems and more particularly, but not exclusively, to a method and system for dynamically adjusting the active power synchronisation loop in grid-connected STATCOM systems based on impedance and voltage information to enhance performance under varying operating conditions.

### BACKGROUND

Synchronisation is essential for grid-connected electrical systems, for example Static Synchronous Compensators (STATCOMs). In grid-forming controlled converters, an active power-based synchronisation is commonly used. These grid-forming systems synchronise their internal voltage phase with the grid depending on the desired steady-state active power flow. However, achieving synchronisation can be challenging under dynamic conditions, such as grid faults, power constraints, and fluctuations in grid impedance or voltage amplitude.

Active power synchronisation requires active power exchange with the grid, where active power is either fed into or absorbed from the system to align its voltage and phase with the grid's. However, significant active power flow can create limitations, particularly during faults or energy-constrained scenarios, where rapid synchronisation with minimal active power flow is critical. Without efficient synchronisation, grid-connected systems risk instability, degraded performance, or failure.

The dynamics of active power synchronisation are influenced by grid impedance, system voltage amplitudes, system voltage phase angles, and physical and/or virtual impedances of the connected converters, which can depend on the converter control algorithms. Changes in these parameters during operation affect the system's angle-to-active power response, making synchronisation less predictable. Existing methods fail to account for these real-time variations, resulting in inconsistent synchronisation performance.

Known methods for improving synchronisation typically use fixed-gain control loops, where a predetermined gain regulates active power responses. While effective under nominal conditions, this approach cannot adapt to real-time variations in grid impedance or voltage, leading to suboptimal performance. Other methods estimate system parameters like grid reactance or voltage to adjust control settings. However, these approaches can lack the precision or adaptability required to handle dynamic grid conditions.

Some systems rely on outer controllers or additional hardware to regulate active power synchronisation, but these solutions increase system complexity, cost, and response latency. Methods requiring offline measurements or manual calibration introduce downtime, further disrupting system operation and reducing efficiency.

There is a need for an adaptive, efficient method for active power synchronisation that accounts for real-time variations in grid impedance and voltage amplitude. Such a method would enable faster and more consistent synchronisation while minimising active power flow. This would improve system stability and reliability, especially during grid disturbances or energy-constrained scenarios.

The present invention addresses these issues by introducing a dynamic adjustment mechanism for the active power synchronisation loop. The method leverages real-time measurements of grid impedance and voltage to dynamically modify the control gain based on the ratio of nominal to estimated angle-to-active power dynamics. This ensures reliable and rapid synchronisation under varying operating conditions without additional hardware or downtime. By dynamically adjusting synchronisation behaviour, the invention enhances system stability, reduces maintenance requirements, and ensures efficient operation of grid-connected devices such as STATCOMs and other grid-forming systems.

### SUMMARY OF THE INVENTION

In an aspect, there is provided a method of method of adjusting active power synchronisation in a grid-connected electrical system as defined in the appended independent method claim. Further preferable steps of the method of adjusting active power synchronisation in a grid-connected electrical system are defined in the appended dependent apparatus claims.

According to a further aspect there is provided a system for executing the method of adjusting active power synchronisation in a grid-connected electrical system as defined in the appended independent system claim. Further preferable features of the system are defined in any appended dependent system claims.

The method of adjusting active power synchronisation in a grid-connected electrical system comprises the steps of measuring the grid voltage amplitude (V), internal voltage amplitude (E), and grid impedance (*X_{g}*) during system operation, determining the phase angle difference (θ) between the internal voltage and grid voltage, calculating estimated angle-to-active power dynamics of the system based on the measured grid voltage amplitude, internal voltage amplitude, grid impedance, and the phase angle difference between the internal and grid voltages, and assigning the result as *G_{θ-to-P,est}*(*s*), determining nominal angle-to-active power dynamics based on predefined system design parameters and assigning the result as *G_{θ-to-P,nom}*(*s)*, calculating an adjustment gain as the ratio of *G_{θ-to-P,nom}*(*s*) to *G_{θ-to-P,est}*(*s*); and applying the adjustment gain to an active power synchronisation loop by modifying control parameters within the loop based on the calculated adjustment gain.

The method of the present invention tends to offer several key technical advantages that enhance the performance, adaptability, and reliability of grid-connected electrical systems.

For example, the method utilizes continuous measurement of critical grid parameters, including voltage amplitudes (*V* and *E*) and grid impedance (*X_{g}*), during system operation to ensure that the active power synchronisation loop responds dynamically to changes in grid conditions, such as fluctuations in impedance, voltage amplitude, or phase angle. This adaptability significantly improves the system's ability to synchronise effectively, and during transient events or grid disturbances, minimising the risk of instability or performance degradation.

By calculating the estimated angle-to-active power dynamics (*G_{θ-to-P,est}*(*s*) using measured parameters and comparing them to the nominal dynamics *G_{θ-to-P,nom}*(*s*) derived from predefined design parameters, the method may ensure a high degree of precision in synchronisation. The adjustment gain calculated as the ratio of these dynamics tends to provide a tailored correction to the synchronisation loop, allowing the system to compensate for deviations between the actual and ideal operating states. This can improve the overall accuracy and reliability of the synchronisation process.

The calculated adjustment gain dynamically may modify the control parameters within the synchronisation loop. This tends to ensure that the system requires desirable active power exchange to achieve synchronisation. This is particularly advantageous during energy-constrained scenarios or grid faults, where excessive active power flow could exacerbate system instability. By optimising active power usage, the method may enhance energy efficiency while maintaining stable operation.

Advantageously, the method may also be highly scalable and applicable to various grid-connected systems, including STATCOMs, grid-forming inverters, and other power electronics-based systems, with minimal hardware modifications by leveraging existing sensors and control infrastructure. The ability to use grid parameters measured in real time to dynamically adjust the synchronisation loop tends to improve fault tolerance, enabling rapid stabilisation during disturbances such as faults or voltage sags, thereby reducing downtime and enhancing system reliability. Additionally, the data generated by the method may be stored and analysed for predictive maintenance. This tends to allow operators to identify trends, anticipate issues, and optimise control strategies for long-term efficiency. By providing a precise, adaptive, and cost-effective solution, the method represents a significant advancement over traditional synchronisation techniques, offering robustness, scalability, and enhanced performance for modern power grids.

As an example assuming the grid and the system impedances are predominantly reactive, a precise and adaptable mathematical model for the angle-to-active power dynamics in a grid-connected system can be estimated using the relationship: ${G}_{θ - to - P} \left(s\right) = \frac{EV}{{X}_{eff} + {X}_{g}} cos \left(θ\right)$, in which (*X_{eff}*) is a known internal parameter representing the effective reactance of the system tends to provide. By incorporating measurable parameters such as internal voltage amplitude (*E*), grid voltage amplitude (*V*), grid impedance (*X_{g}*), and the phase angle difference (θ), the relationship may allow for accurate real-time representation of system behaviour, ensuring reliable synchronisation under varying operating conditions. The effective reactance of the system can be the physical reactance of the converter reactor and/or the transformer, a virtual reactance implemented by the converter controller, a combination of the previous two, or the converter output impedance that includes contributions from physical components and the controller.

The use of *X_{eff}* as a known internal parameter tends to simplify control implementation by reducing the need for additional measurements or estimations, enabling efficient computation with minimal complexity. This can also help real-time adaptability, as changes in grid conditions, such as variations in *V, X_{g},* or θ can be dynamically accounted for to optimise the active power synchronisation loop. By separating the system's internal effective reactance from external grid reactance, the equation may enable precise internal adjustments while maintaining stability and efficiency.

The inclusion of the phase relationship cos (*θ*) tends to ensure that active power synchronisation is responsive to the effective power exchange needed, minimising unnecessary active power flow and enhancing energy efficiency. Such a dynamic response tends to improv fault tolerance, particularly during grid disturbances, by allowing rapid recalibration of the synchronisation loop to stabilise the system. Furthermore, the relationship may provide a clear baseline for system design by enabling comparisons between nominal and real-time dynamics, supporting proactive control tuning and predictive system optimisation.

The step of continuously, in real-time, measuring the grid voltage amplitude (*V*), internal voltage amplitude (*E*), and grid impedance (*X_{g}*) during system operation tends to provide the advantage of enabling the system to dynamically adapt to changing grid conditions. By maintaining a constant flow of updated data, the method may enable calculation of system dynamics and subsequent adjustments to be based on the most current operating conditions, thus improving synchronisation precision and response speed. Real-time measurement tends to also enhance fault tolerance, as the system can immediately detect and respond to fluctuations or disturbances, and can ensure stable, efficient operation without delays caused by outdated or static data.

The method may further comprise the step of applying transition logic, such as ramping or delays, to ensure smooth application of the adjustment gain to the active power synchronisation loop and to avoid abrupt changes or instability. This tends to ensure the smooth integration of the adjustment gain into the active power synchronisation loop, preventing abrupt changes that could lead to instability or oscillations. Such an approach may maintain system stability during dynamic adjustments by gradually modifying control parameters, enabling the synchronisation process to respond seamlessly to changing grid conditions.

Preferably, the method further comprises the step of storing data on measured grid parameters, calculated dynamics, and applied adjustment gains in a data storage system. This may provide a foundation for long-term system monitoring and optimisation, including update of the nominal values. By preserving this data, the system enables analysis of historical trends, identification of recurring patterns, and evaluation of performance over time. This facilitates predictive maintenance, allowing operators to anticipate potential issues and address them proactively. Additionally, stored data can be used to refine control algorithms and improve future system designs, enhancing both the efficiency and reliability of grid-connected operations.

The method may further comprise the steps of identifying control cycles or data points for exclusion based on predefined criteria, including the magnitude of measured grid parameters, the number of connected components, or the presence of transient disturbances, and excluding said identified control cycles or data points from analysis. This tends to ensure that only reliable and meaningful data is used for analysis. By filtering out cycles with anomalies such as low grid parameter magnitudes, insufficient connected components, or transient disturbances, the method avoids skewed calculations and potential inaccuracies. This targeted exclusion enhances the precision of dynamic adjustments, maintains the integrity of the synchronisation process, and reduces the risk of instability caused by erroneous or noisy data.

Preferably, the method further comprises the step of normalising the measured grid voltage amplitude and internal voltage amplitude by dividing each measurement by a predefined reference value corresponding to the nominal operating condition of the system. This may ensure consistency and comparability of the data under varying operating conditions and standardise the measurements relative to the system's nominal operating state, reducing the influence of scaling differences or outliers. By providing a consistent basis for calculations, this step enhances the accuracy of dynamic adjustments and improves the overall reliability of the active power synchronisation process.

Advantageously, the method further comprises the step of applying digital filtering to the measured grid voltage amplitude, internal voltage amplitude, and grid impedance by processing the measurements through a digital filter configured to attenuate high-frequency components or fluctuations in the data. Such a step may enhance the accuracy and reliability of the measurements by reducing the impact of noise and high-frequency fluctuations. By processing the data through a filter configured to attenuate such components, the method tends to ensure that calculations of system dynamics are based on cleaner, more stable inputs. This can improve the precision of dynamic adjustments in the active power synchronisation loop and reduce the risk of instability or errors caused by transient or noisy measurements.

The method may further comprise the step of configuring thresholds for acceptable deviations between nominal and estimated dynamics by defining deviation limits in a control system, and monitoring real-time deviations to trigger an alert signal when the measured deviation exceeds the predefined threshold. This can enable the system to monitor performance in real-time and quickly identify abnormal conditions. By defining precise deviation limits within the control system, the method tends to ensure that any significant discrepancies are flagged immediately, triggering an alert signal. Such a proactive approach can enhance system reliability by allowing timely corrective action, reducing the risk of prolonged instability or performance degradation.

Preferably, the method further comprises incorporating sensors to measure environmental conditions, and adjusting the measured grid voltage amplitude, internal voltage amplitude, or grid impedance based on the environmental data using predefined compensation algorithms. Incorporating sensors to measure environmental conditions and adjusting the measured grid voltage amplitude, internal voltage amplitude, or grid impedance using predefined compensation algorithms improves the accuracy and reliability of system calculations. By accounting for external factors such as temperature or humidity, this step tends to ensure that environmental variations do not distort the measured parameters. The use of compensation algorithms can allow the system to maintain precise control and consistent performance, even under fluctuating environmental conditions, enhancing overall system stability and efficiency.

The method may further comprise applying the adjustment gain to multiple points within the control system, including modifying input control signals and intermediate feedback loop parameters, to implement dynamic adjustments based on real-time calculations of system dynamics. By distributing the gain across different control layers, the method can enable fine-tuned modifications that optimise various aspects of the synchronisation loop. Multi-point application can ensure a more balanced and effective response to real-time system dynamics, improving stability, adaptability, and overall performance under varying operating conditions.

Preferably, the method further comprises the step of dynamically estimating or adjusting the effective reactance (*X_{eff}*) during operation by measuring grid voltage and current, calculating the reactance using predefined algorithms, and updating control parameters in real-time to reflect the adjusted effective reactance. This tends to ensure that the synchronisation loop remains accurate and responsive.

The method may further comprise detecting grid faults or disturbances by monitoring deviations in measured grid parameters, including voltage amplitude, impedance, and phase angle, and modifying control parameters in the synchronisation loop based on predefined fault-handling algorithms to account for the detected deviations. This tends to enable the system to identify and respond to anomalies in real time, enhancing fault tolerance, minimising downtime, and reducing the risk of cascading failures.

A system for executing the above disclosed method may comprise: a grid-connected electrical system configured to synchronise with a power grid; at least one sensor configured to measure grid voltage amplitude, internal voltage amplitude, and system and/or grid current during operation; a processor configured to calculate the estimated angle-to-active power dynamics of the system and/or the grid impedance, determine nominal angle-to-active power dynamics, and compute an adjustment gain based on the ratio of nominal to estimated dynamics; a control system configured to apply the adjustment gain to the active power synchronisation loop by modifying control parameters to dynamically adjust the loop gain; and wherein the processor and control system are further configured to implement transition logic to ensure the smooth application of the adjustment gain during system operation.

The sensors of the system may be configured to measure environmental parameters, and the processor may be configured to adjust the calculated dynamics to compensate for environmental variations. This tends to ensure that environmental variations do not adversely affect system performance, enhancing the accuracy and reliability of synchronisation.

Advantageously, the control system is configured to apply an adjustment gain to multiple points within the active power synchronisation loop, including input control signals and intermediate feedback loops, to optimise specific aspects of the loop's performance. This tends to allow for finer control of the loop's performance which can improve stability and adaptability under varying operating conditions.

Preferably, the processor is configured to store historical data related to measured grid parameters, calculated dynamics, and applied adjustment gains in a data storage system for offline analysis and predictive maintenance. This tends to facilitate long-term optimisation and proactive system management.

The processor may be configured to apply digital filtering to the measured grid voltage amplitude, internal voltage amplitude, and grid impedance. This tends to reduce noise and improve the accuracy of the calculated dynamics.

The control system may also be configured to identify and exclude control cycles or data points from analysis based on predefined criteria, including the magnitude of measured parameters or the presence of transient disturbances. This tends to ensure that only reliable data is used for analysis and improving the accuracy of the synchronisation process.

The control system may be configured to implement user-defined thresholds for acceptable deviations between nominal and estimated dynamics and to trigger an alert when the measured deviation exceeds the predefined threshold. This tends to enable proactive monitoring and timely corrective action. Preferably, the processor is further configured to dynamically estimate or adjust the effective reactance of the system during operation based on measured grid conditions. This tends to ensure precise control and adaptability to changing operating scenarios.

Advantageously, the processor is configured to detect grid faults or disturbances by monitoring deviations in grid parameters, including voltage amplitude, impedance, and phase angle, and the control system is configured to modify synchronisation control parameters based on predefined fault-handling algorithms. This tends to enable with the control system to maintain stability.

The transition logic preferably includes a ramping mechanism or predefined time delays to ensure smooth application of the adjustment gain and to avoid oscillations in the synchronisation loop. This tends to prevent oscillations and maintain stability in the synchronisation loop.

The sensors may be configured to operate continuously during real-time system operation and may be further capable of detecting rapid changes in grid parameters during transient events. This tends to enable timely and accurate system responses.

It will also be appreciated that at least some of the quantities described herein could be obtained through communication means.

Within the scope of this application, it is expressly intended that the various aspects, embodiments, examples, and alternatives set out in the preceding paragraphs, and the claims and/or the following description and drawings, and in particular the individual steps and/or features thereof, may be taken independently or in any combination. That is, all embodiments and all steps and features of any embodiment can be combined in any way and/or combination, unless such features are incompatible.

### BRIEF DESCRIPTION OF THE DRAWINGS

Figure 1 is a simplified diagram of a grid-connected STATCOM; and
Figure 2 is a control block diagram of active power synchronisation loop; and
Figure 3 is a control block diagram of active power synchronisation loop showing the proposed adjustment of the present invention.

### DETAILED DESCRIPTION

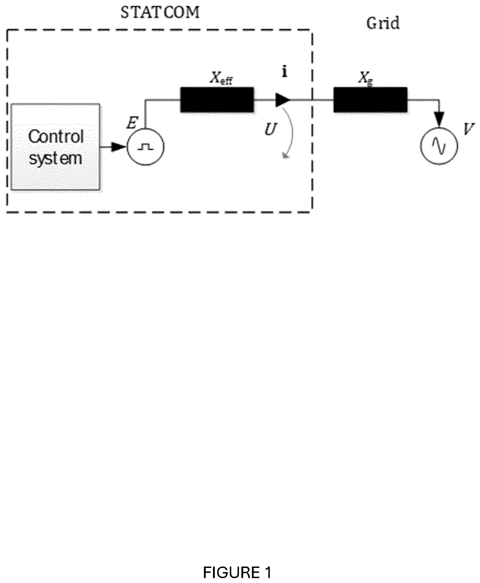

Referring firstly to Figure 1, this shows a simplified diagram of a grid-connected grid-forming Static Synchronous Compensator (STATCOM). The figure highlights the key components and their interactions within the system. The STATCOM includes a control system which generates an internal voltage amplitude, denoted as (E). The STATCOM is connected to the grid, represented by a grid voltage amplitude (V), through a series of reactance elements.

The first reactance, (*X_{eff}*), represents the STATCOM's effective reactance, which is an internal parameter used for controlling the system's dynamic response. The second reactance, *X_{g}*, represents the grid reactance, which characterises the impedance of the electrical grid. The current flow between the STATCOM and the grid is denoted by *i*, and the interaction between the internal voltage (*E*), the reactance elements, and the grid voltage (*V*) determines the power exchange and synchronisation of the system.

A control input, denoted as (*U*), is received by the control system. The signal (*U*) represents a measurement variable that is influenced by the operation of the STATCOM and by the grid voltage and the grid impedance, and the signal *U* influences the operation of the STATCOM since the control system can use the signal to adjust the internal voltage amplitude or phase to improve synchronisation with the grid. The control system influences (*U*) based on real-time measurements of system conditions, adjusting the STATCOM's response dynamically to achieve stable operation.

This figure provides a broad conceptual basis for understanding the interaction between control inputs, system reactance, and power exchange mechanisms in a grid-connected STATCOM. It highlights the role of dynamic regulation in ensuring efficient and stable synchronisation under varying grid conditions.

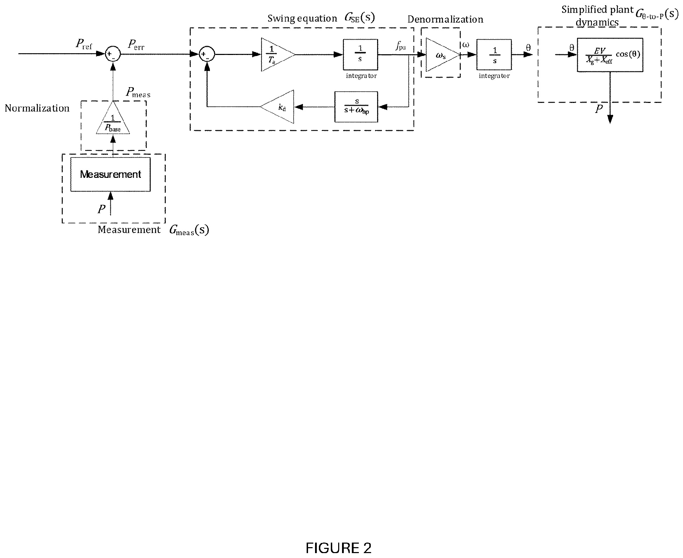

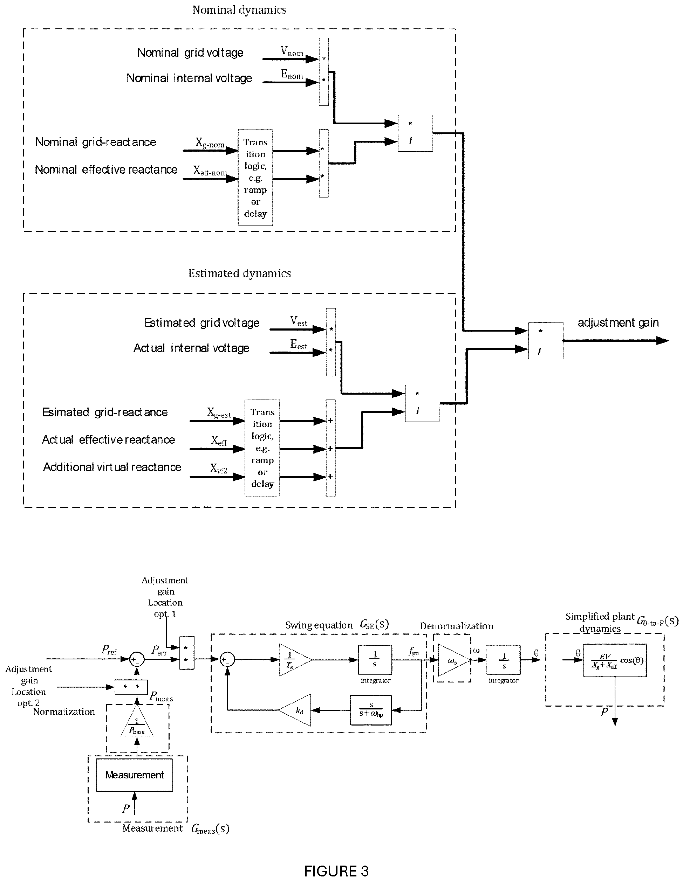

Referring now to Figure 2, this shows a control block diagram illustrating the active power synchronisation process in a STATCOM application. Active power synchronisation loop refers to a closed-loop control system within a grid-connected electrical system, such as a grid-forming STATCOM or grid-forming inverter, which regulates the exchange of active power between the system and the grid to achieve and maintain synchronisation. The loop dynamically adjusts control parameters based on real-time measurements of grid voltage amplitude (*V*), internal voltage amplitude (*E*), grid impedance (*X_{g}*)and the phase angle difference (θ) between the internal and grid voltages. This is shown most clearly in Figure 3.

The synchronisation loop operates by comparing a reference active power value *P_{ref},* typically generated by an outer controller, to the actual active power value (*Pₘₑₐₛ*) measured within the system. The resulting error signal (*Pₑᵣᵣ*) is processed through the loop to modify specific control variables - such as the phase angle, or gain parameters - thereby aligning the internal dynamics of the system with the grid. The loop incorporates components such as the swing equation, plant dynamics, and gain adjustment mechanisms to ensure stability and performance under varying grid conditions.

The application of an adjustment gain (shown in Figure 3), derived as the ratio of nominal to estimated angle-to-active power dynamics, modifies the behaviour of the synchronisation loop by dynamically adjusting its control parameters. Transition logic, such as ramping or delays, may also be included to apply changes smoothly, avoiding instability or oscillations.

As mentioned, the synchronisation begins with an active power reference (*P_{ref}*), which is generated by an outer controller, such as a DC terminal voltage controller in a grid-forming STATCOM. The active power error (*Pₑᵣᵣ*) is calculated by subtracting the measured and normalised active power ( *Pₘₑₐₛ*) from the reference. Normalisation of *Pₘₑₐₛ* is performed by dividing the actual measured power (*P*) by the STATCOM's base active power (*P_{base}*), though *S_{base},* the base apparent power, may be used depending on the design convention.

The measured active power (*P*) is subject to the system's measurement dynamics and filtering, represented by *Gₘₑₐₛ*(*s*). The transfer function *G_{θ-to-P}*(*s*) models the relationship between the phase angle (*θ*) and the active power (P). The phase angle is calculated as an integral of the swing equation's output rotational angular speed (*ω*), which itself is derived by multiplying the swing equation's frequency output (*fₚᵤ*) with the nominal synchronous frequency (*ωₛ*).

The swing equation includes parameters such as the mechanical start-up time constant (*T_{α}*), damping constant (*k_{d}*), and high-pass filter cut-off frequency (*ωₕₚ*). The overall system dynamics are influenced by these parameters, as well as by the STATCOM internal voltage amplitude (*E*), the grid voltage amplitude (*V*), the effective reactance (*X_{eff}*), and the grid reactance (*X_{g}*). The product *G_{θ-to-P}*(*s*) provides the transfer function for the simplified plant dynamics, capturing how variations in phase angle affect active power.

The active power loop gain *L*_{(*s*)} derived from Figure 2 is expressed as: ${L}_{\left(s\right)} = \frac{1}{{P}_{base}} {G}_{meas} \left(s\right) {G}_{θ - to - P} \left(s\right) \frac{1}{s} {ω}_{s} {G}_{SE} \left(s\right)$

Where *Gₘₑₐₛ*(*s*) is assumed to have a unity gain, and the remaining transfer function are: ${G}_{θ - to - P} = \frac{EV}{{X}_{eff} + {X}_{g}} cos \left(θ\right)$

Where (*θ*) is the steady-state angle between E and V. ${G}_{SE} = \frac{1}{{sT}_{a} + {k}_{d} \frac{s}{{ω}_{hp} + s}}$

The closed-loop transfer function from a phase-angle perturbation to the active power can be given by: ${G}_{θ - to - P}^{C} \left(s\right) = \frac{{G}_{θ - to - P} \left(s\right)}{1 + \frac{1}{{P}_{base}} {G}_{meas} \left(s\right) {G}_{θ - to - P} \left(s\right) \frac{1}{s} {ω}_{s} {G}_{SE} \left(s\right)}$

The closed-loop transfer function from the active power reference to the active power can be given by: ${G}_{Pref - to - P}^{C} \left(s\right) = \frac{{G}_{θ - to - P} \left(s\right) \frac{1}{s} {ω}_{s} {G}_{SE} \left(s\right)}{1 + \frac{1}{{P}_{base}} {G}_{meas} \left(s\right) {G}_{θ - to - P} \left(s\right) \frac{1}{s} {ω}_{s} {G}_{SE} \left(s\right)}$

By comparing ${G}_{Pref - to - P}^{C} \left(s\right)$ and ${G}_{θ - to - P}^{C} \left(s\right)$ it can be seen that the denominators are identical, and the numerators differ. Regarding ${G}_{Pref - to - P}^{C} \left(s\right) , \frac{1}{{P}_{base}} {G}_{meas} \left(s\right)$ does not exist in the numerator; and therefore, it can be deduced that adding a gain to different locations of the loop gain can have different effects on the closed-loop transfer function ${G}_{Pref - to - P}^{C} \left(s\right)$.

An embodiment of the present invention provides a method for dynamically adjusting active power synchronisation in grid-connected electrical systems, particularly STATCOM systems, to enhance their ability to maintain stability and efficiency under varying operating conditions. The method relies on continuous measurements of grid parameters, real-time calculation of system dynamics, and precise adjustments to the active power synchronisation loop. By modifying the loop gain in response to changing grid conditions, the system ensures that synchronisation is achieved consistently, with desirable active power flow, even during grid disturbances or scenarios where energy constraints limit the availability of active power exchange.

Figure 3 shows the active power loop block diagram where the proposed solution is highlighted with two example locations. The subscript "nom" denotes the nominal or design value of the variable, and the subscript "est" denotes the estimated actual value of the variable. In the case of effective reactance *X_{eff},* estimation should not be needed because it is an internal variable that is known by the control system.

The method begins by continuously monitoring grid voltage amplitude, internal voltage amplitude, and grid reactance. These parameters are critical to determining the real-time behaviour of the synchronisation process. The internal voltage amplitude (*E*) of the STATCOM represents the effective voltage generated internally by the converter as observed from outside the STATCOM, which must be synchronised with the grid voltage amplitude (*V*). These measurements are obtained using precision sensors integrated into the system. The grid reactance (*X_{g}*) is measured or estimated through direct impedance analysis or inferred from known grid characteristics. Effective reactance (*X_{eff}*), which represents a controllable internal parameter used to modify system impedance, is inherently known by the control system.

The measured and estimated parameters are used to calculate the angle-to-active power dynamics of the system. The dynamics are described by the relationship: ${G}_{θ - to - P} \left(s\right) = \frac{EV}{{X}_{eff} + {X}_{g}} cos \left(θ\right)$ where E is the internal voltage amplitude, V is the grid voltage amplitude, *X_{eff}* is the effective reactance, *X_{g}* is the grid reactance, and *θ* is the phase angle difference between the internal and grid voltages. This formula establishes how changes in these parameters influence the active power response of the system.

Nominal dynamics are determined based on the design parameters of the system. These parameters represent the ideal operating conditions under which the STATCOM is expected to function. For instance, nominal values for internal voltage, grid voltage, reactance, and phase angle are used to compute *G_{θ-to-P,nom}*(*s*), the nominal angle-to-active power dynamics. These dynamics serve as a benchmark for assessing the current operating state of the system.

Real-time measurements are used to calculate the estimated dynamics, *G_{θ-to-P,nom}*(*s*). For example, ${G}_{θ - to - P , est} \left(s\right) = \frac{{E}_{est} {V}_{est}}{{X}_{eff} + {X}_{g , est}} cos \left({θ}_{est}\right)$ where *Eₑₛₜ, Vₑₛₜ,* and *X_{g,est}* represent real-time measurements or estimations of effective internal voltage, grid voltage, and grid reactance, respectively. These estimated dynamics capture the actual behaviour of the system under current grid conditions.

The method calculates an adjustment gain as the ratio of the nominal dynamics to the estimated dynamics. This adjustment gain reflects the deviation of the current operating state from the ideal state. The adjustment gain is applied to the active power synchronisation loop at a specific location within the control system. Two example application points are identified, each offering distinct advantages depending on the desired system response. The choice of location may depend on factors such as system stability, response time, and control precision.

The application of the adjustment gain is managed using transition logic to ensure smooth integration into the control loop. Transition logic may involve ramping the gain over a predefined period or introducing delays to prevent abrupt changes in system behaviour. This approach minimises the risk of oscillations or instability that could arise from sudden adjustments to the loop gain. The adjustment gain modifies the active power loop gain dynamically, ensuring that the synchronisation process remains robust and efficient under varying conditions.

The system optimises the amount of active power exchanged with the grid during synchronisation through dynamic adjustment of the active power loop gain. This is particularly advantageous during grid disturbances, such as faults, or in scenarios where energy availability is limited. For example, in the event of a fault that causes sudden changes in grid impedance, the system can rapidly recalibrate the synchronisation loop to maintain stability without relying on excessive active power flow.

The invention also supports offline analysis by storing historical data on measured parameters, calculated dynamics, and applied adjustments. This data provides a comprehensive record of system performance, enabling operators to identify trends, predict potential issues, and refine control strategies. Offline analysis allows for the detection of gradual changes in grid conditions or system behaviour that may not be immediately apparent during real-time operation. For instance, long-term analysis of grid reactance data may reveal trends indicative of underlying grid instability, allowing operators to take preventive measures.

The system includes a control system with an integrated digital processor to execute the described method. The processor performs high-speed calculations of nominal and estimated dynamics, adjustment gains, and transition logic. It interacts dynamically with the sensors, managing the flow of real-time data and ensuring that adjustments are applied in a timely and precise manner. The processor may be implemented using technologies such as microcontrollers, FPGAs, or DSPs, depending on the performance requirements of the application. The described method and system provide a robust, adaptive approach to active power synchronisation in grid-connected systems. By dynamically modifying the active power loop gain based on real-time measurements and calculated dynamics, the invention ensures stable and efficient synchronisation under a wide range of operating conditions. This reduces the risk of performance degradation, enhances fault tolerance, and minimises operational costs. Furthermore, the ability to store and analyse historical data extends the system's functionality, supporting predictive maintenance and long-term optimisation of grid-connected operations.

The steps of the method of the present invention are therefore as follows:
1. Measuring Grid Parameters
   - Determining at least one of the grid voltage amplitude (*V*), internal voltage amplitude (*E*), or grid impedance (*X_{g}*) during system operation. The effective reactance (*X_{eff}*), being an internal parameter, is inherently known.
2. Estimating Angle-to-Active Power Dynamics:
   - Calculate the estimated angle-to-active power dynamics using determined parameters according to the relationship: ${G}_{θ - to - P} \left(s\right) = \frac{EV}{{X}_{eff} + {X}_{g}} cos \left(θ\right)$ where *θ* is the phase angle difference between the internal and grid voltages. The simple (transfer) function in the previous equation is a gain; nevertheless, a higher-order transfer function between *θ* and *P* can be used alternatively.
3. Determining Nominal Dynamics:
   - Define the nominal angle-to-active power dynamics based on system design or reference parameters, representing the ideal operating state of the system.
4. Calculating the Adjustment Gain:
   - Determine an adjustment gain as the ratio of the nominal dynamics to the estimated dynamics:
   $Adjustment Gain = \frac{{G}_{θ - to - P , nom} \left(s\right)}{{G}_{θ - to - P , est} \left(s\right)}$
5. Applying the Adjustment Gain:
   - Introduce the adjustment gain into the active power synchronisation loop at a selected location within the control system to dynamically modify the loop gain.
6. Implementing Transition Logic:
   - Apply the adjustment gain smoothly using transition logic, such as ramping or delays, to avoid abrupt changes and ensure system stability.
7. Synchronising with the Grid:
   - Use the adjusted loop gain to regulate the active power response, ensuring reliable and efficient synchronisation with desirable active power flow.
8. Storing and Analysing Data (Optional):
   - Record data on measured parameters, calculated dynamics, and applied adjustments for offline analysis to support predictive maintenance and long-term optimisation.

The system components required to perform the method of the present invention may comprise of:
1. Voltage and Impedance Measurement Devices
   - Devices to measure or estimate grid voltage (*E*) and grid impedance (*X_{g}*), such as impedance analysers, mathematical models, and/or dedicated current and voltage probes.
2. Control System
   - A centralised control unit responsible for executing the method steps, including managing data from the sensors and calculating dynamics and adjustment gains.
3. Digital Processor
   - A high-speed processing unit (e.g., microcontroller, FPGA, or DSP) configured to:
      ▪ Calculate nominal and estimated dynamics.
      ▪ Determine the adjustment gain.
      ▪ Execute transition logic for smooth application of the adjustment.
4. Power Electronics
   - Components within the STATCOM or grid-connected system that can implement the adjustments to the active power synchronisation loop, such as modulators or voltage controllers.
5. Data Storage System (Optional)
   - Storage for historical records of grid parameters, dynamics, and adjustments to facilitate offline analysis, trend monitoring, and predictive maintenance.
6. Communication Interface
   - Interfaces for real-time data exchange between sensors, the control system, and the processor.
   - A user interface for configuring parameters, thresholds, and monitoring system performance.
7. Transition Logic Mechanism
   - Software or hardware to implement smooth gain transitions (e.g., ramping mechanisms or delay functions) to avoid instability during adjustments.

The system can implement the described method by combining these components to dynamically adjust power synchronisation, ensuring robust and efficient operation under dynamic grid conditions.

In the context of the disclosed, the control parameters are the variables or settings within the active power synchronisation loop that can be modified to dynamically adjust the system's behaviour and achieve stable synchronisation.

For example:
Adjustment Gain: The adjustment gain calculated as the ratio of nominal to estimated dynamics directly modifies the loop gain. This is central to improving the synchronisation response.

Phase Angle (θ): Adjusting the phase angle difference between the internal and grid voltages could be considered a control parameter since it influences the active power exchange and overall synchronisation.

Voltage Setpoints (*E* or *V*): Adjusting the internal voltage amplitude (*E*) or grid voltage amplitude (V) indirectly impacts the dynamics of the synchronisation loop.

Effective Reactance (*X_{eff}*): As effective reactance is an internal parameter of the STATCOM system, dynamically adjusting it to match grid conditions can be considered a control parameter.

Feedback and Feedforward Signals: Parameters that influence intermediate feedback loops or feedforward controls, such as scaling factors or proportional-integral (PI) control settings, are also likely control parameters.

Frequency Offset (*fₚᵤ*): Adjustments to the synchronisation frequency or nominal frequency (*ωₛ* ) could be part of the control loop.

The control parameters are therefore aspects of the synchronisation loop that can be altered dynamically to improve the system's response to grid conditions.

In the context of the disclosed, the system design parameters are predefined, fixed characteristics of the grid-connected system that reflect the intended or nominal operating conditions. These parameters are typically established during the design phase and are used to calculate the nominal angle-to-active power dynamics, *G_{θ-to-P,nom}*(*s*). However, sometimes it is reasonable to consider that the design parameters change over time, and manual or automatic update can be considered.

Examples of these parameters include:
Nominal Internal Voltage Amplitude *Eₙₒₘ*: The ideal or design value of the STATCOM's effective internal voltage amplitude.

Nominal Grid Voltage Amplitude *Vₙₒₘ*: The expected voltage amplitude of the grid under normal operating conditions.

Nominal Grid Reactance *X_{g,nom}*: The expected reactance of the grid, which may include transformer and line reactance.

Nominal Effective Reactance *X_{eff,nom}:* The designed value of the STATCOM's effective reactance.

Nominal Phase Angle *θₙₒₘ*: The ideal steady-state phase angle difference between the internal voltage and the grid voltage.

These parameters are used to compute *G_{θ-to-P,nom}*(*s*), which represents the angle-to-active power dynamics expected under ideal, nominal conditions.

The compensation algorithm of the present invention is designed to adjust measured or calculated parameters such as grid voltage amplitude, internal voltage amplitude, or grid impedance, based on additional inputs, such as environmental data or known system characteristics, to improve the accuracy and reliability of system operation.

The compensation algorithm could adjust measured grid voltage or impedance values to account for environmental influences, such as temperature or humidity, which may affect sensor readings or system dynamics. It may also apply corrections to measured parameters to address known sensor inaccuracies, including drift or nonlinearities, thereby improving measurement accuracy. Additionally, the algorithm could scale measured parameters to predefined nominal conditions, such as dividing the measured voltage by a reference value, ensuring consistency and reliability in subsequent calculations. Furthermore, the algorithm may continuously update system parameters, including effective reactance or phase angle, to reflect real-time changes in grid conditions, enhancing the overall adaptability and performance of the system.

These algorithms may use predefined mathematical models, calibration curves, or machine-learning techniques to implement corrections and ensure accurate control decisions within the active power synchronisation loop.

It will be apparent that AC voltage is measurable by the converter, including a local measurement of the grid voltage or estimated local grid voltage, and can include the voltage at the Point of Interconnect (POI), Point of Common Coupling (PCC), or Reference Point of Applicability (RPA).

## Claims

1. A method of adjusting active power synchronisation in a grid-connected electrical system, comprising the steps of:
determining at least one of grid voltage amplitude, internal voltage amplitude or grid impedance during system operation;
estimating a phase angle difference between the internal voltage and grid voltage;
calculating estimated angle-to-active power dynamics of the system based on determining at least one of the grid voltage amplitude, internal voltage amplitude, grid impedance, and or the phase angle difference between the internal voltage and grid voltage, and assigning the result as *G_{θ-to-P,est}*(*s*);
determining nominal angle-to-active power dynamics based on at least one predefined system design parameter and assigning the result as *G_{θ-to-p,nom}*(*s*);
calculating an adjustment gain as the ratio of *G_{θ-to-P,nom}*(*s*) to *G_{θ-to-P,est}*(*s*); and
applying the adjustment gain to an active power synchronisation loop by modifying at least one control parameter or modifying the signal within the loop based on the calculated adjustment gain.

2. The method according to claim 1, wherein the step of applying the adjustment gain to the active power synchronisation loop by modifying control parameters comprises applying the adjustment gain to the active power synchronisation loop by adjusting a control gain parameter or other loop-specific control setting to account for the difference between the nominal and estimated dynamics, and/or wherein the step of calculating estimated angle-to-active power dynamics of the system based on the grid voltage amplitude (*V*), internal voltage amplitude (*E*), grid reactance (*X_{g}*), and or the phase angle difference (θ) between the internal and grid voltages, uses the relationship: ${G}_{θ - to - P} \left(s\right) = \frac{EV}{{X}_{eff} + {X}_{g}} cos \left(θ\right)$, in which (*X_{eff}*) is a known internal parameter representing the effective reactance of the system.

3. The method according to any of the preceding claims, wherein the step of determining at least one of the grid voltage amplitude (*V*), internal voltage amplitude (*E*), or grid impedance or reactance (*X_{g}*) during system operation is performed in real-time or as needed by measurement or indirect estimation.

4. The method according to any of the preceding claims, further comprising the step of applying transition logic, such as ramping or delays, to ensure smooth application of the adjustment gain to the active power synchronisation loop and to avoid abrupt changes or instability.

5. The method according to any of the preceding claims, further comprising the step of storing data on measured grid parameters, calculated dynamics, and applied adjustment gains in a data storage system.

6. The method according to any of the preceding claims, further comprising the steps of identifying control cycles or data points for exclusion based on predefined criteria, including the magnitude of measured grid parameters, the number of connected components, or the presence of transient disturbances, and excluding said identified control cycles or data points from analysis.

7. The method according to any of the preceding claims, further comprising normalising the measured grid voltage amplitude and internal voltage amplitude by dividing each measurement by a predefined reference value corresponding to the nominal operating condition of the system.

8. The method according to any of the preceding claims, further comprising applying digital filtering to the measured grid voltage amplitude, internal voltage amplitude, and grid impedance by processing the measurements through a digital filter configured to attenuate high-frequency components or fluctuations in the data.

9. The method according to any of the preceding claims, further comprising configuring at least one threshold for acceptable deviation between nominal and estimated dynamics by defining at least one deviation limit in a control system, and monitoring at least one real-time deviation to trigger an alert signal when the measured deviation exceeds the predefined threshold.

10. The method according claim 9, further comprising applying the adjustment gain to at least one point within the control system, including modifying at least one input control signal and intermediate feedback loop parameters, to implement dynamic adjustments based on real-time calculations of system dynamics.

11. The method according to any of the preceding claims, further comprising incorporating at least one sensor to measure at least one environmental condition, and adjusting the measured grid voltage amplitude, internal voltage amplitude, or grid impedance based on the environmental data using at least one predefined compensation algorithm.

12. The method according to any of the preceding claims, further comprising dynamically estimating or adjusting the effective reactance (*X_{eff}*) during operation by measuring grid voltage and current, calculating the reactance, and updating control parameters in real-time to reflect the adjusted effective reactance.

13. The method according to any of the preceding claims, further comprising detecting grid faults or disturbances by monitoring deviations in measured grid parameters, including voltage amplitude, impedance, and phase angle, and modifying control parameters in the synchronisation loop based on predefined fault-handling algorithms to account for the detected deviations.

14. A system for executing the method of any of the preceding claims, the system comprising:
a grid-connected electrical system configured to synchronise with a power grid;
at least one sensor configured to measure grid impedance during operation;
a processor configured to calculate the estimated angle-to-active power dynamics of the system, determine nominal angle-to-active power dynamics, and compute an adjustment gain based on the ratio of nominal to estimated dynamics;
a control system configured to apply the adjustment gain to the active power synchronisation loop by modifying at least one control parameter to dynamically adjust the loop gain; and
wherein the processor and control system are further configured to implement transition logic to ensure the smooth application of the adjustment gain during system operation.

15. The system of claim 14, wherein the sensors are further configured to measure at least one environmental parameter and the processor is configured to adjust the calculated dynamics to compensate for environmental variation.
